# EUROPEAN PATENT APPLICATION

(11) **EP 1 427 028 A1**
(43) Date of publication of application: **09.06.2004**
(21) Application number: 02767957.0
(22) Date of filing: 12.09.2002
(51) Int. Cl.: H01L 31/08

(54) **ULTRA HIGH−SPEED PHOTOELECTRIC SIGNAL CONVERSION ELEMENT**

(30) Priority: 14.09.2001 JP 2001279311
(71) Applicant: National Institute of Advanced Industrial Science and Technology, Tokyo 100-0013 (JP)
(72) Inventor: IWAI, Shinichiro, Nat. Inst. of Advanced Ind. Sce., Higashi, Tsukuba-shi, Ibaraki 305-8562 (JP); OKAMOTO, Hiroshi, Bunkyo-ku, Tokyo 112-0001 (JP); TOKURA, Yoshinori, Nerima-ku, Tokyo 179-0074 (JP); KANEKO, Yoshio, Chiba-shi, Chiba 263-0005 (JP)
(74) Representative: Smith, Norman Ian
(86) International application number: PCT/JP2002/009353
(87) International publication number: WO 2003/028116

(57) **Abstract**

In a photoelectric signal conversion device comprising a substrate (4), formed thereon a thin film (3) that functions as a light detection portion (5), and a pair of electrodes (2) provided thereon across the light detection portion, the thin film constituting the light detection portion is made of a solid state phase transition material, and the pair of electrodes are made of a superconductive material, whereby the light detection portion can respond to optical signals on the order of psec, and the device can follow ON-OFF signals of terahertz.

## Description

### Technical Field:

This invention relates to a photoelectric signal conversion device and particularly to an ultrahigh speed photoelectric signal conversion device that has a detection portion capable of responding to optical signals on the order of picosecond and following ON-OFF signals of terahertz (10¹² Hz) and that is suitable for integration.

### Background Art:

Conventional photoelectric signal conversion devices include photodiodes that utilize the p-n junction of a semiconductor and photoconductor devices that project light onto the base part of a p-n-p transistor to take out a collector current. Of these, a Si-pin (p⁺nn⁺) diode has a relatively high response speed of 270 psec. and the response speed of a Ge-pin photodiode is 200 psec. (Refer to LSI Handbook, Electron Communications Society, p. 78)

Since optical communications utilizing an optical fiber network can transmit large-scale data at high speed, it is conceivable as a principal communications means for future large-scale data communications. For realizing this, the light switching frequency has to be increased to the maximum. It has already been possible to form optical pulses at a region of several tens of femtoseconds (10⁻¹⁴ second). However, since the light-receiving light-responding portion has a response speed of around the order of 100 psec. as described above, this is a factor that imposes restrictions on the amount of optical communications data. Enhancement in response speed of photoelectric signal conversion devices is being strongly demanded.

The inventors materialized a photoelectric signal conversion device using Mott insulator material at an ultrahigh region in the terahertz region. In the proposed device, however, treatment subsequent to the photoelectric signal conversion is made by means of a device using ordinary metal electrodes. However, at the terahertz region, speed delay will be induced due to metal resistance, capacity between wirings or parasitic capacity between wirings. Therefore, it is necessary to secure high speed of the entire device including the electrodes and wirings. The speed delay becomes a serious problem particularly in view of an application of integrating the device with a highly integrated LSI.
An object of this invention is to provide an ultrahigh speed photoelectric signal conversion device that has a detection portion capable of response to optical signals on the order of psec. and following ON-OFF signals of terahertz.

### Disclosure of the Invention:

This invention provides a photoelectric signal conversion device comprising a light detection portion, a pair of electrodes provided across the light detection portion, and a wiring material, wherein the light detecting portion is made of a solid state phase transition material, and the electrodes and wiring material are made of a superconductive material.

In the photoelectric signal conversion device, the superconductive material constituting the electrodes and wiring material is a superconductive metal material or a copper oxide.

The copper oxide is LnSrₓBa₂₋ₓCu₃O_{6+y} (wherein Ln denotes Y or one of lanthanide elements, 0≤x<1.5 and 0<y<2) or LnSr₂Cu₃₋ₓMₓO_{6+y} (wherein Ln denotes Y or one of lanthanide elements, M denotes Tl, Pb or Bi, 0<x≤1 and 0<y<2).

In the photoelectric signal conversion device, the solid state phase transition material is a Mott insulator, which is a transition metal oxide.

The transition metal oxide is a copper oxide, which is a one-dimensional copper oxide, A₂CuO₃ (wherein A denotes Ca, Sr, Ba or one of La system atoms), or a two-dimensional copper oxide, A₂CuO₄ or A₂CuO₂Cl₂ (wherein A denotes Ca, Sr, Ba or one of La system atoms).

As described above, the photoelectric signal conversion device of the present invention comprises a light detection portion of transition metal oxide, in which photo-induced insulator-metal transition is generated, and electrodes and wiring material, each of superconductive material, whereby the light detection portion can respond to optical signals on the order of psec. and follow ON-OFF signals of terahertz.

### Brief Description of the Drawings:

Figure 1 is a perspective view illustrating one embodiment of the photoelectric signal conversion device according to the present invention.
Figure 2(a) is a diagram showing the crystal structure of Sr₂CuO₃ or Ca₂CuO₃ used for the light detection portion of the photoelectric signal conversion device according to the present invention.
Figure 2(b) is a diagram showing the crystal structure of LaSrAlO₃ used for the substrate of the photoelectric signal conversion device according to the present invention.
Figure 2(c) is an explanatory view showing a multilayer structure of LaSrAlO₄ and Sr₂CuO₃ or Ca₂CuO₃ and the lattice constants thereof.

### Best Mode for Carrying our the Invention:

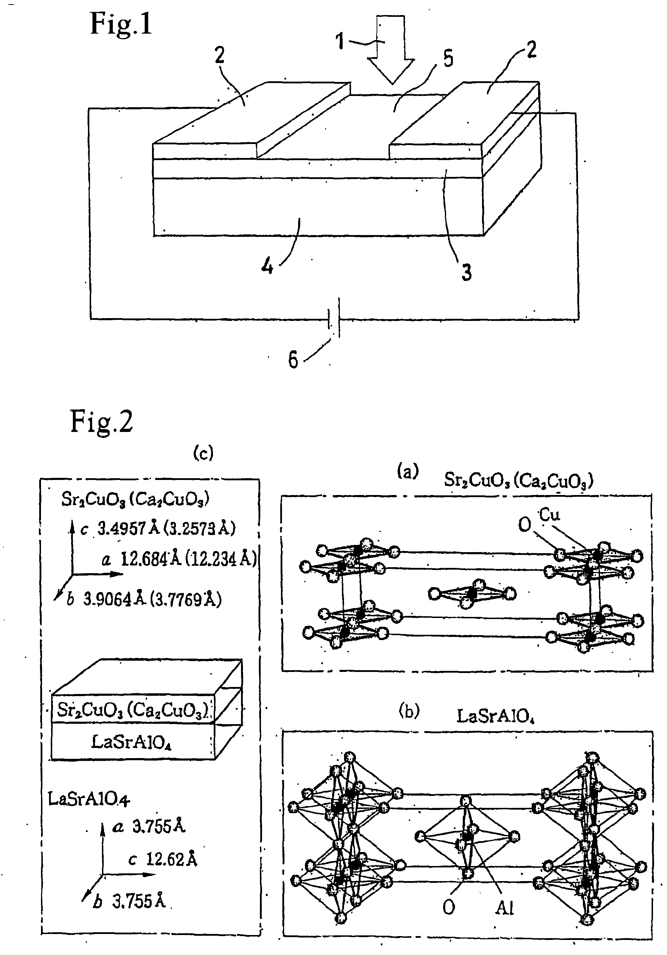

Figure 1 is a perspective view illustrating one embodiment of the photoelectric signal conversion device according to the present invention, in which a thin-film portion 3 of solid state phase transition material is formed on a substrate 4 to form a light detection portion 5, across which a pair of electrodes 2 of superconductive material is formed.

Light pulses 1 are detected by means of the thin-film portion 3 of solid state phase transition material that is the light detection portion 5, and converted current pulses become photoelectric signals. Denoted by reference numeral 5 is a constant-voltage power source.

As the solid state phase transition material, a Mott insulator can be used. More specifically, transition metal oxides can be raised. Especially, copper oxides that are matrix substances for recently developed high-temperature superconductive materials can advantageously be used.

Examples of the copper oxides include one-dimensional copper oxides, such as A₂CuO₃ (wherein A denotes Ca, Sr, Ba or one of La system atoms), and two-dimensional copper oxides, such as A₂CuO₄ and A₂CuO₂Cl₂ (in each of which A denotes Ca, Sr, Ba or one of La system atoms).

Figure 2(a) shows the crystal structure of Sr₂CuO₃ or Ca₂CuO₃, and Figure 2 (c) shows the lattice constants thereof.

The superconductive material constituting the pair of electrodes 2 provided across the light detection portion 5 includes metal superconductive materials and copper oxides.

Examples of the metal superconductive materials include Nb and Pb, and examples of the oxides include LnSrₓBa₂₋ₓCu₃O_{6+y} (wherein Ln denotes Y or one of lanthanide elements, 0<x≤1 and 0<y<2) and LnSr₂Cu₃₋ₓMₓO_{6+y} (wherein Ln denotes Y or one of lanthanide elements, M denotes Tl, Pb or Bi, 0<x≤1 and 0<y<2).

When the photoelectric signal conversion device includes a wiring material, such as a metallic line electrically connecting the electrodes 2 and constant-voltage power source 6, the wiring material is formed of the same superconductive material, such as metal superconductive material or copper oxide, as constituting the electrodes.

The substrate 4 of the photoelectric signal conversion device can be formed of LaSrAlO₄, which has small lattice mismatching with the transition metal oxide constituting the light detection portion 5 that generates photo-induced insulator-metal transition and which can form a Mott insulator extremely good in quality. The crystal structure of LaSrAlO₄ is shown in Figure 2(b) and Figure 2(c) shows the multiplayer structure of the same and the transition metal oxide, and their lattice constants. It can be seen that the lattice constant af LaSrAl₄ is approximate to that of Sr₂CuO₃ or Ca₂CuO₃ shown in Figure 2(a) and constituting the light detection portion 5.

The substrate 4 and thin-film portion 3 can be formed through the ordinary molecular beam epitaxy (MBE) method. The thin-film portion can also be formed through laser ablation MBE.

The electrodes and wiring material can be formed on the light detection portion by means of FIB (Focused Ion Beam) method using a superconductive material.

As described above, since the photoelectric conversion is conducted using insulator-metal transition at the light detection portion of the photoelectric signal conversion device according to the present invention, the light detection portion can respond to optical signals on the order of psec., and since the electrodes and wiring material are made of superconductive material, the light detection portion can follow ON-OFF singals of terahertz.

An actual photoelectric signal conversion apparatus comprises a group of photoelectric signal conversion devices as a principal component, and a large-scale arithmetic circuitry. In this case, when the photoelectric signal conversion device of the present invention is used for the photoelectric signal conversion apparatus, the electrical signal converted from light, in which the resistance component thereof becomes zero even in the case of the electrical signal being passed through the large-scale wiring and circuitry, can be propagated without any signal delay.

While the present invention will be described with reference to Examples, the present invention is not limited to these Examples.

### Example 1:

A substrate of LaSrAlO₄ was used, and a thin film of Sr₂CuO₃ was formed thereon as a light detection portion using the laser ablation MBE method.

It could be confirmed from observation of optical spectral anisotropy that the thin film thus formed was a good-quality crystal film.

A sputtering apparatus was used to form a Nb metal film on the thin film, ordinary photolithography and etching technologies were used to form electrodes, and the laser ablation method was used to deposit a LaAlO₃ film as a protective film. As a consequence, the photoelectric signal conversion device shown in Figure 1 was fabricated.

The photoelectric signal conversion device was cooled to 4.2 K using liquid He and observed in respect of its response to light signals. It was consequently confirmed that the device replied to the light signals on the order of psec.

### Example 2:

A thin film of Sr₂CuO₃ was formed on a substrate of LaSrAlO₄ in the same manner as in Example 1, and a thin film of Yba₂Cu₃O₇ that is a copper oxide superconductive material was then formed thereon. Subsequently, the FIB method was used to peel the thin film of Yba₂Cu₃O₇ off the LaSrAlO₄ film that became the light detection portion. In this case, in order to minimize a damage of the light detection portion by beams of the FIB method, the ion beams were projected from the side surface of the light detection portion to peel off the thin film of Yba₂Cu₃O₇. Though the film of Sr₂CuO₃ was peeled off by around several nm at that time, the film has no problem for functioning as the light detection portion, for the length of light invasion is as long as the light wavelength. Thus, the electrodes and light detection portion were formed. Furthermore, the laser ablation method was used to deposit a LaAlO₃ film as a protective film.

The photoelectric signal conversion device thus fabricated was cooled to 77 K using liquid nitrogen and observed in respect of its response to light signals. It was consequently confirmed that the device could operate without any difficulty though the signal intensity was made slightly weaker than the device of Example 1 using the Nb metal film as the electrodes.

### Industrial Applicability:

As has been described in the foregoing, the present invention can provide a photoelectric signal conversion device utilizing an insulator metal transition. The insulator-metal transition generated in the light detection portion of the photoelectric signal conversion device is widely generated in a Mott insulator. The material thereof is a one-dimensional copper oxide, A₂CuO₃ (wherein A denotes Ca, Sr, Ba or one of La system atoms) or a two-dimensional copper oxide, A₂CuO₄ (wherein A denotes Ca, Sr, Ba or one of La system atoms) of a matrix substance for recently developed high-temperature superconductive materials and can respond to light signals on the order of psec. and therefore can follow ON-OFF signals of terahertz.

The ultrahigh speed photoelectric signal conversion phenomenon can be secured by the use of not only the light detection portion but also the electrodes and wiring material a superconductive material. Since the photo-induced insulator-metal transition material and superconductive material are relatively stable materials, these materials can also be combined with a Si semiconductor. In addition, copper oxide superconductive materials can relatively readily be made superconductive by low-temperature conversion means using liquid nitrogen and can provide practically great merits. Moreover, the copper oxide superconductive materials are compatible with Si materials. It is therefore possible to combine the step of performing direct communications from optical fibers in tera-Hz region and its signal processing at the superconductor computing portion, with the ultrahigh speed photoelectric signal conversion device as a center, and the step of calculation processing the delayed part using a conventional Si-LSI. Thus, the photoelectric signal conversion device of the present invention has a probability of serving as a principal role in the optical communication and information industry that would play the leading part as future data communication means. It is expected that the present invention provides a great deal of effects as means for bridging ultrahigh optical communications particularly in the tera-Hz region, future ultrahigh speed Si semiconductors in which a gate is miniaturized to 0.1 µm or less, and ultrahigh speed computation for GaAs semiconductors.

## Claims

1. A photoelectric signal conversion device comprising a light detection portion, a pair of electrodes provided across the light detection portion, and a wiring material, wherein the light detection portion is made of a solid state phase transition material, and the pair of electrodes and wiring material are made of a superconductive material.

2. The photoelectric signal conversion device according to claim 1, wherein the superconductive material constituting the electrodes and wiring material is a superconductive metal material or a copper oxide.

3. The photoelectric signal conversion device according to claim 1, wherein the superconductive material constituting the electrodes and wiring material is a copper oxide.

4. The photoelectric signal conversion device according to claim 3, wherein the copper oxide is LnSrₓBa₂₋ₓCu₃O_{6+y} (wherein Ln denotes Y or one of lanthanide elements, 0≤x<1.5 and 0<y<2).

5. The photoelectric signal conversion device according to claim 3, wherein the copper oxide is LnSr₂Cu₃₋ₓMₓO_{6+y} (wherein Ln denotes Y or one of lanthanide elements, M denotes Tl, Pb or Bi, 0<x≤1 and 0<y<2).

6. The photoelectric signal conversion device according to any one of claims 1 to 5, wherein the solid state phase transition material constituting the light detection portion is a Mott insulator.

7. The photoelectric signal conversion device according to claim 6, wherein the Mott insulator is a transition metal oxide.

8. The photoelectric signal conversion device according to claim 7, wherein the transition metal oxide is a copper oxide.

9. The photoelectric signal conversion device according to daim 8, wherein the copper oxide is a one-dimensional copper oxide, A₂CuO₃ (wherein A denotes Ca, Sr, Ba or one of La system atoms).

10. The photoelectric signal conversion device according to claim 8, wherein the copper oxide is a two-dimensional copper oxide, A₂CuO₄ or A₂CuO₂Cl₂ (wherein A denotes Ca, Sr, Ba or one of La system atoms).
